# EUROPEAN PATENT APPLICATION

(11) **EP 1 914 557 A2**
(43) Date of publication of application: **23.04.2008**
(21) Application number: 07118214.1
(22) Date of filing: 10.10.2007
(51) Int. Cl.: G01R 31/06

(54) **Insulation-resistance degradation detecting device for motors**

(30) Priority: 20.10.2006 JP 2006286821
(71) Applicant: FANUC LTD, Minamitsuru-gun, Yamanashi 401-0597 (JP)
(72) Inventor: Horikoshi, Shinichi, Shibokusa Minamitsuru-gun, Yamanashi 401-0511 (JP); Sato, Hiroyasu, Shibokusa Minamitsuru-gun, Yamanashi 401-0511 (JP); Hirai, Akira, Shibokusa Minamitsuru-gun, Yamanashi 401-0511 (JP); Tanabe, Satoshi, Oshino-mur Minamitsuru-gun, Yamanashi 401-0511 (JP); Yaeshima, Mamoru, Kawasaki-shi Kanagawa 213-0022 (JP)
(74) Representative: Billington, Lawrence Emlyn

(57) **Abstract**

An insulation-resistance degradation detecting device capable of selecting one of a plurality of motors and detecting its insulation-resistance degradation. A power source unit is connected with a plurality of motor drive amplifiers which drive two motors, individually. The motor is selected by selecting means, and a contactor S1 or S2 is turned on. When a smoothing capacitor C of the power source unit reaches a predetermined voltage after an electromagnetic contactor is turned off, contactors SW1 and SW2 are turned on, whereupon one end of the smoothing capacitor C, contactor SW2, resistors R1 and R2, contactor S1 or S2, coil of the motor, insulation resistor Rx of the motor, grounds G2 and G1, contactor SW1, and the other end of the smoothing capacitor C form a closed circuit. The voltage of the smoothing capacitor C is applied to this closed circuit. A potential difference across the detection resistor R1 is obtained and compared with a reference voltage to detect insulation-resistance degradation. The single insulation-resistance degradation detecting device can detect insulation degradation of the plurality of motors, so that a space-saving configuration can be obtained at low cost.

## Description

### BACKGROUND OF THE INVENTION

### 1. Field of the Invention

The present invention relates to an insulation-resistance degradation detecting device for detecting insulation degradation of motors.

### 2. Description of Related Art

After prolonged continuous use of a motor, its insulation is degraded depending on its working environment. A leakage breaker is actuated by a leakage current that is attributable to the insulation degradation, whereupon a device that uses the motor suddenly stops its operation. In such a case, it is unknown whether the motor or a driver has a problem, and investigation of the causes of the sudden stop takes a lot of time. Thus, the device that uses the motor and its production line tend to stop their operations for a long period of time.

Conventionally, insulation degradation of a motor has been detected based on the aforesaid leakage current detection. According to a detecting method using a conventional leak detector, however, the motor insulation degradation can be detected only in its advanced stage such that the leakage current has a considerable value.

Accordingly, there is proposed a motor driving apparatus which is provided with a power source unit for rectifying a three-phase AC power source and converting it into a DC power source and a motor amplifier that converts a DC power source, such as an inverter circuit, into an AC power source and drives a motor (see JP 3751300B). In this motor driving apparatus, insulation degradation of the motor can be detected at low cost by utilizing the voltage of a smoothing capacitor in the power source unit.

The motor insulation-resistance degradation detecting device used in the motor driving apparatus described in JP 3751300B is provided in a motor drive amplifier. If the motor driving apparatus includes a plurality of motor drive amplifiers for driving motors, each amplifier must be provided with insulation-resistance degradation detecting means for the motor that is driven by it, thus requiring a wider space and entailing a higher cost.

### SUMMARY OF THE INVENTION

The present invention provides an insulation-resistance degradation detection device for a plurality of motors capable of successively selecting one of the motors and detecting degradation of insulation-resistance of the selected motor at low cost in a motor driving apparatus for driving the motors.

An insulation-resistance degradation detecting device of the present invention is provided for a plurality of motors driven by a motor driving apparatus having a power supply section for supplying a DC voltage by rectifying an electric power supplied from an AC power source through a power switch and smoothing the electric power by a capacitor, driving amplifiers for respectively driving the motors associated therewith by converting the DC voltage supplied from the power supply section into an AC voltage, and a drive control section for controlling the power switch and the driving amplifiers. The insulation-resistance degradation detecting comprises: a contactor for connecting one end of the capacitor to the ground when turned ON; control means arranged to turn the contactor ON in accordance with a signal to turn the power switch OFF from the drive control section; a conductive line for connecting the other end of the capacitor with a coil of one of the motors so as to form a closed circuit including the contactor being turned on, the capacitor, the coil of the one of the motors and the ground; motor selecting means arranged to select the one of the motors so that a coil of the selected one of the motors is included in the closed circuit; and detecting/determining means arranged to detect an electric current flowing through the closed circuit and determine degradation of the insulation-resistance of the selected one of the motors based on the detected electric current.

The motor selecting means may comprise one of a relay, an electromagnetic contactor and a semiconductor switch for selecting the one of the motors to be included in the closed circuit.

The contactor, the control means, the conductive line, the motor selecting means and the detecting/determining means may be incorporated in the motor driving apparatus.

According to the arrangement described above, the single insulation-resistance degradation detecting device can detect insulation degradation of the plurality of motors, so that a space-saving configuration can be obtained at low cost.

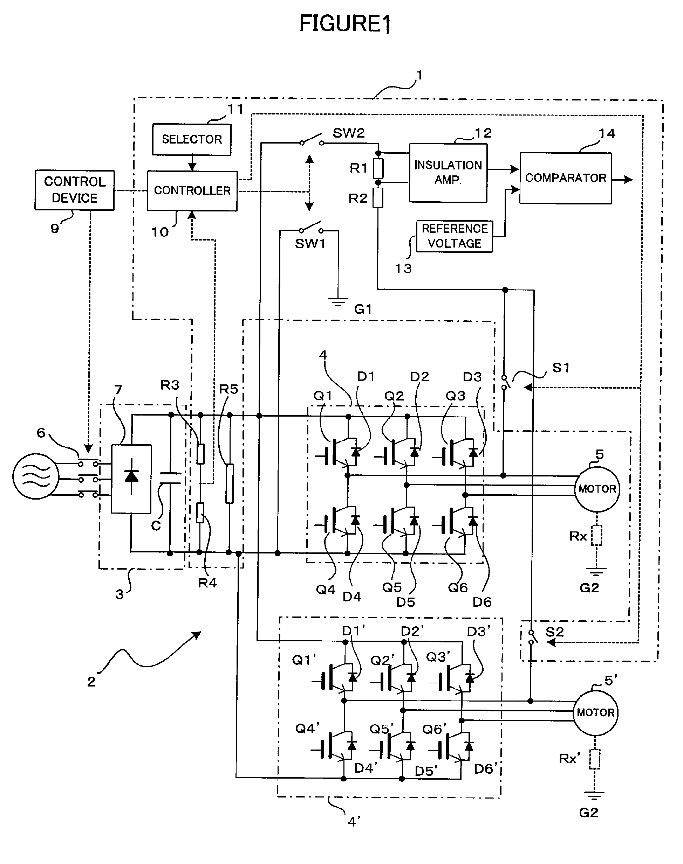

### BRIEF DESCRIPTION OF THE DRAWING

FIGURE is a schematic block circuit diagram showing an insulation-resistance degradation detecting device and a motor driving apparatus according to an embodiment of the present invention.

### DETAILED DESCRIPTION

FIGURE is a schematic block circuit diagram showing an insulation-resistance degradation detecting device and a motor driving apparatus according to an embodiment of the present invention.

In FIGURE, numeral 2 denotes a motor driving apparatus. The motor driving apparatus 2 is composed of a power source unit 3 and motor drive amplifiers 4 and 4'. The power source unit 3 causes a rectifier circuit 7 to convert a three-phase AC power source into a DC power source. The amplifiers 4 and 4' convert a DC power source into an optional AC power source to drive motors 5 and 5'. Numeral 1 denotes an insulation-resistance degradation detecting device for detecting insulation degradation of the motors. In this embodiment, the power source unit 3 is connected with the two motor drive amplifiers 4 and 4'. In this case, one or more motor drive amplifiers are connected to the power source unit 3.

The power source unit 3 of the motor driving apparatus 2 is provided with the rectifier circuit 7 and a smoothing capacitor C. The rectifier circuit 7 rectifies electric power supplied from the three-phase AC power source through an electromagnetic contactor 6 and converts it into a DC power source. The smoothing capacitor C smoothes the DC output rectified by the rectifier circuit 7.

Further, the motor drive amplifiers 4 and 4' are composed individually of inverter circuits, which include switching elements Q1 to Q6 and Q1' to Q6', each formed of an IGBT or the like, and diodes D1 to D6 and D1' to D6' that are connected in parallel with the switching elements Q1 to Q6 and Q1' to Q6', respectively.

The motor drive amplifiers 4 and 4' are connected to an output line (DC link section) of the rectifier circuit 7 of the power source unit 3 and supplied with a DC voltage.

In response to a command from a control device 9 of the motor driving apparatus 2, the switching elements Q1 to Q6 and Q1' to Q6' of the motor drive amplifiers 4 and 4' are PWM-controlled by a control circuit (not shown), whereby the first and second motors 5 and 5' are drivingly controlled. Further, a contact of the electromagnetic contactor 6 is on/off-controlled in response to the command from the control device 9.

The configuration of the motor driving apparatus 2 described above is not substantially different from that of a conventional motor driving apparatus.

The insulation-resistance degradation detecting device 1 of the present invention is configured to detect insulation-resistance degradation of the first and second motors 5 and 5' that are driven by the motor driving apparatus 2. The insulation-resistance degradation detecting device 1 comprises a controller 10, a selector 11, contactors SW1 and SW2, contactors S1 and S2, resistors R1 and R2, an insulation amplifier 12, a reference voltage generator 13, a comparator 14, voltage-dividing resistors R3 and R4 for dividing voltage across a smoothing capacitor C, and discharge resistor R5 for discharging the smoothing capacitor C.

A signal outputted from the control device 9 to turn the electromagnetic contactor 6 off is inputted to the controller 10. A DC power output line on the negative side of the smoothing capacitor C is configured to be connected to the ground by the contactor SW1. A DC power output line on the positive side of the smoothing capacitor C is configured to be connected to one-phase coils of the motors 5 and 5' through the contactor SW2, detection resistor R1, protective resistor R2, and contactor S1. The contactors SW1, SW2, S1 and S2 may be composed of relay contacts, electromagnetic contactors, semiconductor switches, etc.

Further, the insulation amplifier 12 is connected to the opposite ends of the detection resistor R1 so that it can amplify the potential difference of the detection resistor R1 and output it to the comparator 14. The comparator 14 is configured to compare a reference voltage from the reference voltage generator 13 and the output of the insulation amplifier 12.

The following is a description of insulation degradation detecting operation. In detecting insulation degradation of any of the motors, the operations of the motor drive amplifiers 4 and 4' are stopped, and the motor for which the insulation degradation is to be detected is selected by the selector 11. The controller 10 closes the contactor that corresponds to the motor that is selected by the selector 11. In this embodiment, the contactor S1 is closed when the motor 5 is selected, and the contactor S2 is closed when the motor 5' is selected. Then, a command is issued from the control device 9 to close the electromagnetic contactor 6. The electric power supplied from the three-phase AC power source is rectified by the rectifier circuit 7 and the smoothing capacitor C is charged. When the smoothing capacitor C is fully charged after the passage of a predetermined time, a command is outputted from the control device 9 to open the electromagnetic contactor 6. This command from the control device 9 to open the contactor 6 is also inputted to the controller 10 of the insulation-resistance degradation detecting device 1. On receipt of this signal, the controller 10 receives divided voltages divided by the resistors R3 and R4 and compares them with a preset voltage.

When the electromagnetic contactor 6 is opened, the electric charge with which the smoothing capacitor C is charged is slowly discharged through the discharge resistor R5. The voltage obtained at this point of time is divided by the resistors R3 and R4 and the divided voltages are detected by the controller 10. When the preset voltage is reached, the controller 10 outputs a motor insulation degradation detection command and turns on the contactors SW1 and SW2. Thereupon, the charge voltage of the smoothing capacitor C is applied to the coil of the motor 5 or 5' that is selected through the detection resistor R1. Thus, the power output line on the positive side of the smoothing capacitor C forms a closed circuit including the contactor SW2, detection resistor R1, protective resistor R2, contactor S1 or S2, one-phase coil of the motor 5 or 5', insulation resistor Rx or Rx' of the motor 5 or 5' (including a parasitic capacitor of the motor), ground G2 or G1, contactor SW1, and negative-side terminal of the smoothing capacitor C. The charge voltage of the smoothing capacitor C is applied to this closed circuit, whereupon a current (leakage current) corresponding to the insulation resistor Rx or Rx' of the motor flows through the closed circuit. The potential difference across the detection resistor R1 generated by this current is amplified by the insulation amplifier 12 and compared with the reference voltage from the reference voltage generator 13 by the comparator 14. If the output voltage of the insulation amplifier 12 is higher than the reference voltage, an insulation degradation signal is outputted from the comparator. The insulation degradation signal is inputted to an indicator such as a lamp (not shown), thereby informing an operator of insulation degradation of the selected motor. Alternatively, the insulation degradation signal is inputted to the control device 9 and displayed on a display unit of the control device 9.

If the insulation resistor Rx or Rx' of the selected motor is degraded, the current (leakage current) that flows through the closed circuit increases, so that the potential difference across the detection resistor R1 becomes greater, and the output voltage from the insulation amplifier 12 increases. If this voltage is higher than the reference voltage, the insulation degradation signal is outputted from the comparator 14. Thereafter, the motors are selected in succession by the selector 11 and checked for insulation resistance degradation.

Thus, the insulation degradation of each motor can be detected with ease. Since a power source for the detection of the insulation degradation of the motor is energy with which the smoothing capacitor C is charged, the insulation degradation of the motor can be easily detected at low cost.

Although the contactor SW2 is provided in the embodiment described above, it is not essential. The DC power output line on the positive side of the smoothing capacitor C may be directly connected to one end of the detection resistor R1 in advance. When a preset voltage is reached by the voltage of the smoothing capacitor divided by the resistors R3 and R4, in this case, the controller 10 closes the contactor SW1 in response to the then outputted motor insulation degradation detection command and also closes the contactor (S1 or S2) selected by the selector 11, thereby forming the closed circuit.

In the present embodiment, moreover, the insulation-resistance degradation detecting device 1 is provided with the voltage-dividing resistors R3 and R4 and the discharge resistor R5 for detecting the voltage of the smoothing capacitor C. Alternatively, however, the motor driving apparatus 2 itself may be provided with voltage-dividing resistors and a discharge resistor for detecting the voltage of the smoothing capacitor C. In this case, the voltage of the smoothing capacitor C that is detected by the voltage-dividing resistors of the motor driving apparatus 2 should only be inputted to the detecting device 1.

If the charge voltage of the smoothing capacitor C reaches a predetermined value and varies little with the electromagnetic contactor 6 closed for a predetermined time or longer, furthermore, the voltage-dividing resistors R3 and R4 and the discharge resistor R5 for detecting the voltage of the smoothing capacitor C may be omitted. In this case, the controller 10 receives a signal to open the electromagnetic contactor 6 from the control device 9. In a predetermined time, it may output the motor insulation degradation detection command so that the contactors SW1 and SW2 are closed to form the closed circuit. The charge voltage of the smoothing capacitor C is applied to the closed circuit.

## Claims

1. An insulation-resistance degradation detecting device for a plurality of motors driven by a motor driving apparatus having a power supply section for supplying a DC voltage by rectifying an electric power supplied from an AC power source through a power switch and smoothing the electric power by a capacitor, driving amplifiers for respectively driving the motors associated therewith by converting the DC voltage supplied from said power supply section into an AC voltage, and a drive control section for controlling said power switch and said driving amplifiers, said insulation-resistance degradation detecting comprising:
a contactor for connecting one end of said capacitor to the ground when turned ON;
control means arranged to turn said contactor ON in accordance with a signal to turn said power switch OFF from said drive control section;
a conductive line for connecting the other end of said capacitor with a coil of one of the motors so as to form a closed circuit including said contactor being turned on, said capacitor, said coil of the one of the motors and the ground;
motor selecting means arranged to select the one of the motors so that a coil of the selected one of the motors is included in the closed circuit; and
detecting/determining means arranged to detect an electric current flowing through said closed circuit and determine degradation of the insulation-resistance of the selected one of the motors based on the detected electric current.

2. An insulation-resistance degradation detecting device according to claim 1, wherein said motor selecting means comprises one of a relay, an electromagnetic contactor and a semiconductor switch for selecting the one of the motors to be included in the closed circuit.

3. An insulation-resistance degradation detecting device according to claim 1, wherein said contactor, said control means, said conductive line, said motor selecting means and said detecting/determining means are incorporated in said motor driving apparatus.
